Europäisches Patentamt

European Patent Office

Office européen des brevets

(11) Publication number: **0 228 470**
**B1**

(12) **EUROPEAN PATENT SPECIFICATION**

(45) Date of publication of patent specification: **17.01.90**

(51) Int. Cl.⁵: **F 28 D 9/00, H 05 K 7/20**

(21) Application number: **86903591.5**

(22) Date of filing: **11.06.86**

(86) International application number:
**PCT/JP86/00290**

(87) International publication number:
**WO 86/07441 18.12.86 Gazette 86/27**

(54) **HEAT EXCHANGER.**

(30) Priority: **15.06.85 JP 129138/85**

(43) Date of publication of application:
**15.07.87 Bulletin 87/29**

(45) Publication of the grant of the patent:
**17.01.90 Bulletin 90/03**

(84) Designated Contracting States:
**DE FR GB**

(56) References cited:
**EP-A-0 029 577
DE-A-2 055 255
DE-A-2 847 525
JP-U-54 159 258
US-A-4 298 059
US-A-4 384 611**

(73) Proprietor: **FANUC LTD
3580, Shibokusa Aza-Komanba Oshino-mura
Minamitsuru-gun Yamanashi 401-05 (JP)**

(72) Inventor: **ONUKI, Tadayoshi 1882-35, Shindo
Sagamihara-shi
Kanagawa 228 (JP)**

(74) Representative: **Billington, Lawrence Emlyn
et al
HASELTINE LAKE & CO Hazlitt House 28
Southampton Buildings Chancery Lane
London WC2A 1AT (GB)**

Courier Press, Leamington Spa, England.

## Description

This invention relates to an improvement applicable to a heat exchanger. More specifically, this invention relates to an improvement applicable to a heat exchanger which is preferably, but not necessarily employable for cooling the inside of an electronics control cubicle or the like in which electronic equipments are confined or housed.

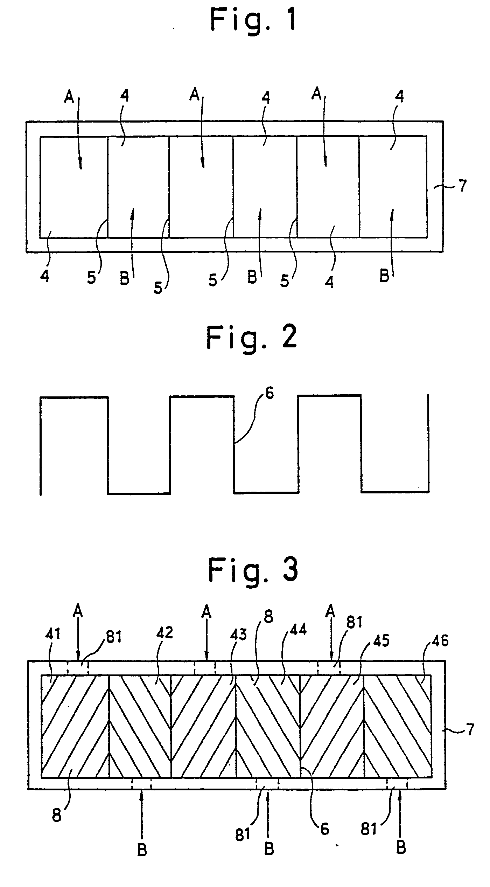

Fig. 1 illustrates the plan view of a previously proposed plate type heat exchanger which is employable for cooling the inside of an electronic control cubicle or the like. The plate type heat exchanger does not comprise a chamber through which flows alternately a cooling fluid and a fluid to be cooled, but comprises a combination of a cooling fluid path and a cooled fluid path. The cooling fluid path is continuously supplied with a cooling fluid and the cooled fluid path is continuously supplied with a fluid to be cooled, whereby the cooling fluid cools the fluid to be cooled through a wall which separates the cooling fluid path and the cooled fluid path. This heat exchanger has an advantage to effectively protect the inside of an electronic control cubicle from potential contamination by dusts, harmful chemical materials, et al. Referring to the drawing, the numeral 4 indicates tubular fluid paths each having a rectangular cross-section. A plurality of the tubes 4, which are stuck to each other in parallel to each other, is aligned in a direction perpendicular to the page of the drawing. The tubes of which the numbers are odd (first tube, third tube, et al.) are supplied with for example a cooling fluid A, and the tubes of which the numbers are even (second tube, fourth tube, et al.) are supplied with for example a fluid to be cooled B. Thereby heat is transmitted between the cooling fluid and the cooled fluid through walls 5 which separate the fluid paths 4 placed side by side.

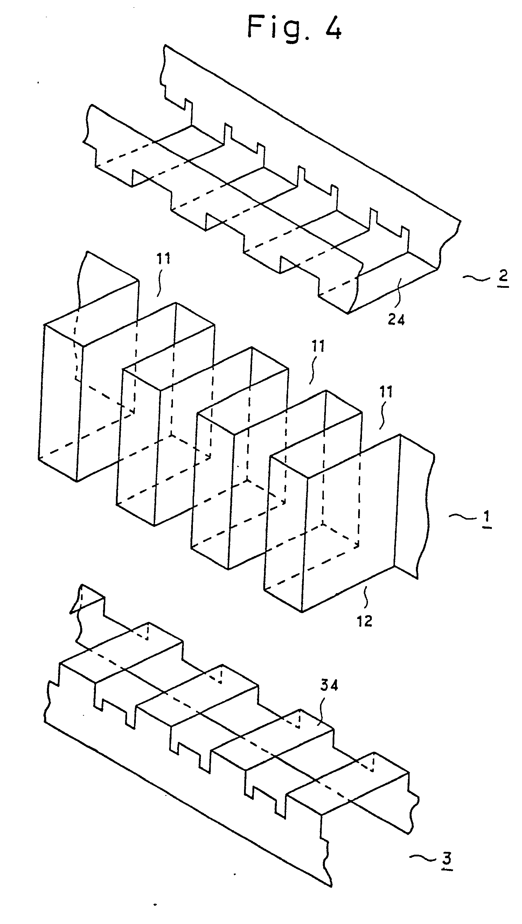

An example of the previously proposed methods for fabricating the plate type heat exchanger having the aforementioned structure will be described below. Referring to Fig. 2, a thin metal plate 6 is formed in the cross-sectional shape of a rectangular wave formed plate. Referring to Fig. 3, the rectangular wave formed plate 6 is inserted in an external shell 7 of the heat exchanger (a tube having a large rectangular cross-section, or a box from which the top and bottom plates are removed), before the top and bottom openings of the external shell 7 are closed with sealing members 8 of rubber or the like which are stuck to the external shell 7 with an adhesive or the like.

The numeral 81 indicates inlets or outlets for the fluids A, B. The cooling fluid A and the fluid to be cooled B are respectively flowed through the fluid paths 4 having every other number. Namely, the cooling fluid A flows in the fluid flow paths 41, 43 and 45, and the fluid to be cooled B flows in the fluid flow paths 42, 44 and 46. In other words, the fluid flow paths having the odd numbers (or even numbers) pass the cooling fluid A and the fluid flow paths having the even numbers (or odd numbers) pass the fluid to be cooled B. Heat is exchanged between the cooling fluid A and the fluid to be cooled B through the wall of the formed thin metal plate 6. The other equipments attached to the plate type heater exchanger are a duct (not shown) connecting the inlets (or outlets) 81 of the fluid paths 41, 43 and 45 in which the cooling fluid A flows, a further duct (not shown) connecting the inlets (or outlets) 81 of the fluid paths 42, 44 and 46 in which the fluid to be cooled B flows, a pushing fan (not shown), a pulling fan, et al. The flow directions of the cooling fluid A and the fluid to be cooled B can be freely selected. In other words, they can be either the same as each other or opposite to each other.

As was described above, the plate type heat exchanger having the aforementioned structure is fabricated with a method comprising a step to form a thin metal plate 6 to a rectangular wave formed plate, a step to insert the thin metal plate formed or a rectangular wave formed plate 6 into an external shell 7, and a step to close the top and bottom openings of the external shell 7 with sealing members 8 of rubber or the like which are stuck to the external shell 7 with an adhesive or the like, for the purpose to produce a plurality of fluid paths 4 which are arranged in parallel side by side. Since the sealing process inherently needs a considerable length of working time or man power, the aforementioned method for fabricating a plate type heat exchanger involves the drawback that the manufacturing cost is high.

To remove this drawback, the inventor developed and proposed a plate type heat exchanger illustrated in Fig. 4 and which comprises a body 1 of a formed plate having a cross-section of rectangular wave form, a top end cover 2 of a formed plate having plural top closing members 24 for closing the top openings 11 of the body 1 of which the numbers are odd (or even), and a bottom end cover 3 of a formed plate having plural bottom closing members 34 for closing the bottom openings 12 of the body 1 of which the numbers are even (or odd).

This improved heat exchanger has successfully realized advantages that: the fabrication process is easy; the hardness or strength thereof is improved in all directions; and the construction thereof is a sort of "monocoque body", whereby the strength is sizably improved. However, since this improved heat exchanger has top and bottom end covers 2, 3 which are formed objects of thin plates, as shown in Fig. 4, the improved heat exchanger is still involved with drawbacks such as a considerable amount of man power or working time is required to assemble the top and bottom end covers 2, 3 with the body 1, and the strength is not necessarily sufficient unless the thickness of the plates, particularly of the top and bottom end covers 2 and 3, is sizably large.

According to the present invention there is provided a heat exchanger comprising a body of a formed plate having a cross-section of substantially rectangular wave form, a top end cover on the body and having a plurality of projections arranged facing top openings of said body, and a bottom end cover on the body and having a plurality of projections arranged facing bottom openings of said body, wherein each end cover is of formed plastics and has its projections extending into respective successive ones of the corresponding openings of the body, the successive projections of each end cover being separated from one another by slits into which are inserted corresponding end edges of the body, in each end cover alternate ones of said projections having openings therein, these openings of one end cover being displaced with respect to the openings of the other end cover, so that each projection with an opening of one end cover faces at the other end of the body a projection of the other end cover which does not have an opening, thereby to provide for the heat exchanger a first set of fluid paths having inlets or outlets provided by said openings at one end of the heat exchanger, and a second set of fluid paths which alternate with the first fluid paths and which have inlets or outlets provided by said openings at the other end of the heat exchanger.

A preferred embodiment of the invention can provide a heat exchanger permitting an easier alignment of the body, an easier fabrication process, and having improved strength and airtightness.

A preferred embodiment of the invention is more fully described with reference to the accompanying drawings in which:

Fig. 1 is a sectional plan view of a previously proposed plate type heat exchanger;

Fig. 2 is a plan view of a thin metal formed plate constituting the heat exchange elements of the plate type heat exchanger of Fig. 1;

Fig. 3 is a plan view of the top end of the plate type heat exchanger of Fig. 1;

Fig. 4 is a partly disassembled perspective view of an improved previously proposed plate type heat exchanger;

Fig. 5 is a plan view of the body of a heat exchanger in accordance with one embodiment of this invention;

Fig. 6 is a plan view of the top or bottom end cover of a heat exchanger in accordance with one embodiment of this invention (The construction of the top and bottom end covers is virtually identical to each other);

Fig. 7 is A—A cross-sectional view of the top or bottom end cover of Fig. 6 seen from the A—A direction (The construction of the top and bottom end covers is virtually identical to each other);

Fig. 8 is a partly disassembled perspective view of a heat exchanger in accordance with the one embodiment of this invention; and

Fig. 9 is a front view of a heat exchanger in accordance with the one embodiment of this invention.

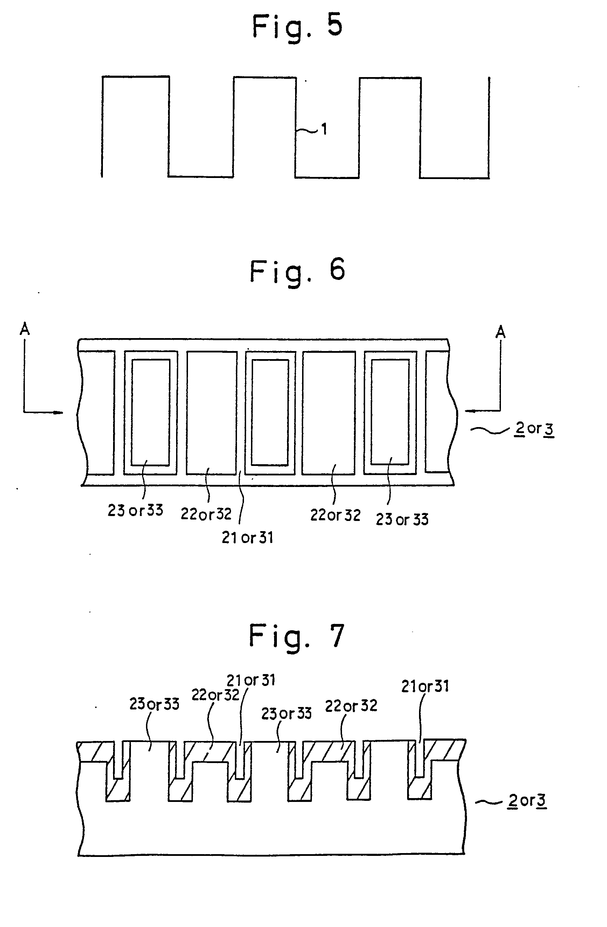

Referring to Fig. 5, a plane plate of a metal or the like is formed to a body 1 having a cross-section of rectangular wave form.

Referring to Fig. 6, top and bottom end covers 2, 3 having a plan view thereof shown in Fig. 6 are formed from a plastics material. Each of the top and bottom end covers 2, 3 has a plurality of rectangular projections 22, 32 facing the top or bottom openings 11, 12 of the body 1, and each of the rectangular projections 22, 32 lies between two slits 21, 31 into which the top or bottom end of the plate constituting the body 1 is inserted. Every other one of the rectangular projections 22, 32 has an opneing 23, 33 thereon. The openings 23 of the top end cover 2 face the top openings 11 of the body 1 and the openings 33 of the bottom end cover 3 face the bottom openings 12 of the body 1.

Referring to Fig. 7, the cross-section of the top and bottom end covers 2, 3 is made hollow to an extent to which the rigidity of strength thereof is sufficient.

It is inherently possible to produce a formed plastics of any complicated shape having a large magnitude of rigidity or strength by properly selecting the thickness thereof, resulting in a smaller possibility of deformation during the fabrication process. The aforementioned top and bottom end covers 2, 3 are of course allowed to enjoy these advantages.

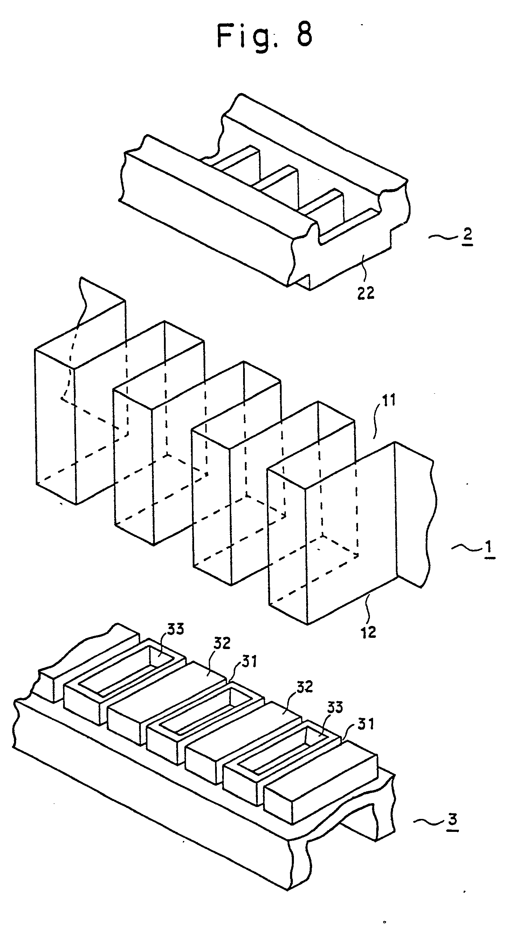

Referring to Fig. 8, the top end of the thin metal plate which constitutes the body 1 is inserted into the slits 21 which separate the projections 22 of the top end cover 2 in the manner that the top openings 11 of the body 1 are aligned to the projections 22 of the top end cover 2, for the purpose to assemble the top end cover 2 with the body 1. Needless to emphasize, the top openings 11 of the body 1 of which the numbers are odd (or even) must be combined with the openings 23 of the top end cover 2.

In the same manner, the bottom end of the thin metal plate which constitutes the body 1 is inserted into the slits 31 which separate the projections 32 of the bottom end cover 3 in the manner that the bottom openings 12 of the body 1 are aligned to the projections 32 of the bottom end cover 3, for the purpose to assemble the bottom end cover 3 with the body 1. Needless to emphasize, the bottom openings 12 of the body 1 of which the numbers are even (or odd) must be combined with the openings 33 of the bottom end cover 3. Sinkce the projections 22, 32 are allowed to act as "jigs" during the aforementioned assembly process, provided the depth and width of the slits 21, 31 are selected at an optimum value, the described construction makes the assembly process easier and enhances the magnitude of airtightness of the heat exchanger.

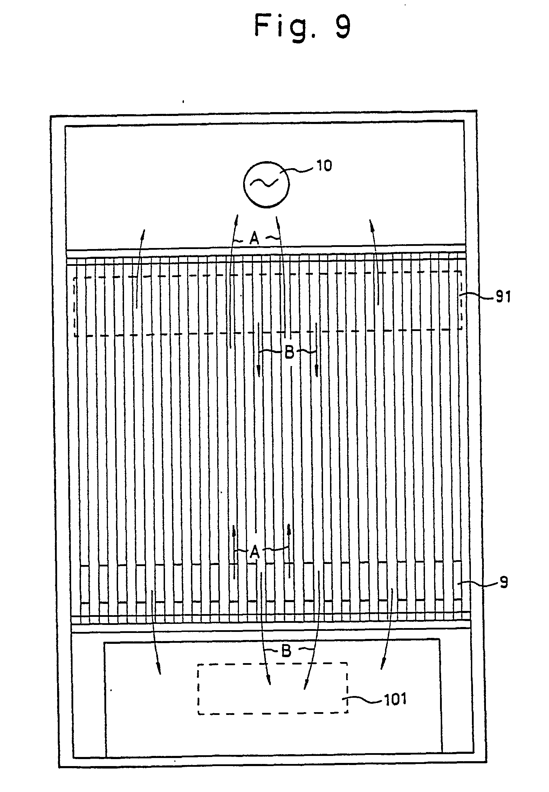

Fig. 9 illustrates the front view of a complete plate type heat exchanger in accordance with one embodiment of this invention. The cooling fluid A flows into the body 1 through a cooling fluid inlet 9 which is arranged at the front bottom of the body 1 of the heat exchanger, before it flows upward in the body 1 and is drafted outward by a fan 10 arranged at the front top of the heat exchanger. On the other hand, the fluid to be cooled B flows from the inside of an electronics cubicle into the body 1 of the heat exchanger through an inlet 91 of the fluid to be cooled which is arranged at the rear top of the body 1 of the heat exchanger, before it flows downward in the body 1 of the heat exchanger and is drafted back into the electronics cubicle through an outlet 101 arranged at the rear bottom of the heat exchanger. A drafting fan (not shown) can be arranged at the outlet 101.

**Claim**

A heat exchanger comprising a body (1) of a formed plate having a cross-section of substantially rectangular wave form, a top end cover (2) on the body (1) and having a plurality of projections (22) arranged facing top openings (11) of said body (1), and a bottom end cover (3) on the body (1) and having a plurality of projections (32) arranged facing bottom openings of said body (1), wherein each end cover (2, 3) is of formed plastics and has its projections extending into respective successive ones of the corresponding openings (11, 12) of the body (1), the successive projections of each end cover (2, 3) being separated from one another by slits into which are inserted corresponding end edges of the body (1), in each end cover (2, 3) alternate ones of said projections (22, 23) having openings therein, these openings of one end cover (2) being displaced with respect to the openings of the other end cover (3), so that each projection with an opening of one end cover (2) faces at the other end of the body (1) a projection of the other end cover (3) which does not have an opening, thereby to provide for the heat exchanger a first set of fluid paths having inlets or outlets provided by said openings at one end of the heat exchanger, and a second set of fluid paths which alternate with the first fluid paths and which have inlets or outlets provided by said openings at the other end of the heat exchanger.

**Patentanspruch**

Wärmetauscher mit einem Körper (1) aus einer geformten Platte, die einen Querschnitt hat, der im wesentlichen eine Rechteckwellenform aufweist, einer oberen Seitenabdeckung (2), die auf dem Körper (1) sitzt und eine Vielzahl von Erhebungen (22) hat, welche so angeordnet sind, daß sie oberen Öffnungen (11) des Körpers (1) gegenüberzustehen, und einer unteren Seitenabdeckung (3), die auf dem Körper (1) sitzt und eine Vielzahl von Erhebungen (32) hat, welche so angeordnet sind, daß sie unteren Öffnungen des Körpers (1) gegenüberstehen, wobei jede Seitenabdeckung (2, 3) aus geformten Kunststoffmaterialien besteht und ihre Erhebungen derart aufweist, daß diese sich in betreffende aufeinanderfolgende der korrespondierenden Öffnungen (11, 12) des Körpers (1) hinein erstrecken, wobei die aufeinanderfolgenden Erhebungen jeder Seitenabdeckung (2, 3) durch Schlitze voneinander getrennt sind, in die korrespondierende Seitenkanten des Körpers (1) eingesetzt sind, wobei in jeder Seitenabdeckung (2, 3) abwechselnde der Erhebungen (22, 23) Öffnungen in sich aufweisen und wobei diese Öffnungen einer Seitenabdeckung (2) in bezug auf die Öffnungen der anderen Seenabdeckung (3) versetzt sind, so daß jede mit einer Öffnungen versehene Erhebung einer Seitenabdeckung (2) auf der anderen Seite des Körpers (1) einer Erhebung der anderen Seitenabdeckung (3) gegenübersteht, die keine Öffnung aufweist, um dadurch für den Wärmetauscher einen ersten Satz von Flüssigkeitsbahnen, die Einlässe oder Auslässe haben, welche durch die Öffnungen auf der einen Seite des Wärmetauschers gegeben sind, und einen zweiten Satz von Flüssigkeitsbahnen zu schaffen, die sich mit den ersten Flüssigkeitsbahnen abwechseln und Einlässe oder Auslässe haben, welche durch die Öffnungen auf der anderen Seite des Wärmetauschers gegeben sind.

**Revendication**

Un échangeur de chaleur comprenant une pièce principale (1) en tôle mise en forme ayant une section droite sensiblement en forme d'ondes rectangulaires, une fermeture d'extrémité supérieure (2) sur la pièce principale (1) comportant plusieurs parties en saillie (22) agencées en face des ouvertures supérieures (11) de ladite pièce principale (1), et une fermeture d'extrémité inférieure (3) sur la pièce principale (1) comportant plusieurs parties en saillie (32) agencées en face d'ouvertures inférieures de ladite pièce principale (1), dans lequel chaque fermeture d'extrémité (2, 3) est en matière plastique mise en forme et possède des parties en saillie se plaçant respectivement à l'intérieur de certaines des ouvertures correspondantes successives (11, 12) de la pièce principale (1), les parties en saillie successives de chaque fermeture d'extrémité (2, 3) étant séparées l'une de l'autre par des fentes dans lesquelles sont introduites les arêtes d'extrémité correspondantes de la pièce principale (1), dans chaque fermeture d'extrémité (2, 3) une sur deux desdites parties en saillie (22, 23) ayant des ouvertures formées à l'intérieur, ces ouvertures d'une fermeture d'extrémité (2) étant décalées par rapport aux ouvertures de l'autre fermeture d'extrémité (3), de façon que chaque partie en saillie avec une ouverture sur l'une des fermetures d'extrémité (2) soit placée face à une partie en saillie de la fermeture de l'autre extrémité (3) de la pièce principale (1) qui ne comporte pas d'ouverture, de manière à créer pour l'échangeur de chaleur un premier ensemble de circulations de fluide comprenant des entrées ou des sorties constituées par lesdites ouvertures, à une première extrémité de l'échangeur de chaleur, et un second ensemble de circulations de fluide qui alterne avec les premières circulations de fluide et qui présente des entrées ou des sorties comprenant lesdites ouvertures à l'autre extrémité de l'échangeur de chaleur.

# Fig. 1

# Fig. 2

# Fig. 3

# Fig. 4

# Fig. 5

~1

# Fig. 6

A                                    A

~ 2 or 3

23 or 33   22 or 32        22 or 32   23 or 33

21 or 31

# Fig. 7

21 or 31                          21 or 31

23 or 33   22 or 32    23 or 33   22 or 32

~ 2 or 3

# Fig. 8

# Fig. 9